# DEMANDE DE BREVET EUROPEEN

(11) **EP 4 192 221 A1**
(43) Date de publication de la demande: **07.06.2023**
(21) Numéro de dépôt: 22211305.2
(22) Date de dépôt: 05.12.2022
(51) Int. Cl.: H10N 30/853, H10N 30/079

(54) **PROCÉDÉ DE FORMATION D'UNE COUCHE À BASE D'UN MATÉRIAU PIÉZOÉLECTRIQUE ET DISPOSITIF À ONDE ACOUSTIQUE DE SURFACE UTILISANT UNE TELLE COUCHE**

(30) Priorité: 06.12.2021 FR 2113025
(71) Demandeur: Commissariat à l'énergie atomique et aux énergies alternatives, 75015 Paris (FR)
(72) Inventeur: DUPONT, Florian, 38054 GRENOBLE Cedex 09 (FR); RODRIGUEZ, Guillaume, 38054 GRENOBLE Cedex 09 (FR); SAUZE, Laura, 38054 GRENOBLE Cedex 09 (FR)
(74) Mandataire: Hautier IP

(57) **Abrégé**

L'invention porte sur un procédé de formation d'une couche (30) à base de niobate de lithium ou de tantalate de lithium, dite couche LN/LT, comprenant les étapes suivantes :
- Fournir un substrat (10) à base de silicium,
- Former sur le substrat (10) une couche de nucléation (20),
- Former par épitaxie la couche LN/LT (30) sur la couche de nucléation (20).

Le procédé est caractérisé en ce que la couche de nucléation (20) est choisie à base de matériau III-N.

L'invention porte également sur un dispositif (1) à onde acoustique de surface comprenant une telle couche de nucléation (20).

## Description

### DOMAINE TECHNIQUE

La présente invention concerne, en général, un dispositif à onde acoustique de surface, et plus particulièrement, un procédé de réalisation de la couche à base d'un matériau piézoélectrique formant le cœur de ce dispositif.

### ETAT DE LA TECHNIQUE

Les résonateurs basés sur une structure de type « onde acoustique de surface » dite SAW (acronyme de « Surface Acoustic Wave ») sont historiquement utilisés pour réaliser des filtres RF. Le cœur des résonateurs SAW est composé d'un matériau piézoélectrique qui influence les propriétés finales du filtre.

Le niobate de lithium (LiNbO3) est utilisé depuis plusieurs années en tant que matériau piézoélectrique. Ses propriétés intrinsèques, comme son coefficient de couplage piézoélectrique, pourrait permettre au filtre de résonner à haute fréquence, par exemple à des fréquences supérieures à 5 GHz. Cependant, la synthèse en couche mince de ce matériau est complexe et les exigences liées à sa qualité sont élevées. La couche mince de LiNbO3 doit notamment présenter une haute qualité cristalline et une stœchiométrie contrôlée. Elle doit également présenter une orientation cristalline contrôlée et permettant de maximiser la vitesse de propagation des ondes.

Des solutions permettant de synthétiser du LiNbO3 en couches minces sur un substrat saphir ont été développées. Les applications liées à ces solutions restent cependant limitées. La réalisation de couches minces de LiNbO3 sur un substrat à base de silicium présente un enjeu considérable. Cela permettrait d'envisager une nouvelle génération de dispositifs multifonctionnels comprenant des dispositifs électro-optiques, acoustiques, microélectroniques et/ou de récupération d'énergie en co-intégration sur un même substrat. Une solution consiste à reporter une couche mince de LiNbO3 depuis un substrat donneur, typiquement à partir d'un substrat de LiNbO3 monocristallin, vers un substrat receveur, typiquement un substrat de silicium avec une couche d'oxyde superficielle. Cette solution mettant en œuvre de nombreuses étapes techniques présente un coût significatif. La gamme d'épaisseurs de couche mince atteignable, typiquement supérieure à 200 nm, est également limitée par les contraintes techniques de report.

Le document US7005947 B2 propose une autre solution consistant à former une couche tampon à base d'un oxyde de terres rares sur le substrat à base de silicium, avant d'épitaxier une couche à base de niobate de lithium. Cette solution est néanmoins complexe à mettre en œuvre. Le coût de fabrication d'une telle couche reste élevé. Dans une optique de co-intégration, la compatibilité de ce procédé doit également être améliorée.

Il existe donc un besoin consistant à réaliser une couche à base de niobate de lithium sur un substrat à base de silicium, qui présente une qualité cristalline compatible avec les applications visées, tout en limitant les coûts de réalisation.

Un objectif de la présente invention est de répondre au moins en partie à ce besoin.

En particulier, un objectif de la présente invention est de proposer un procédé de formation d'une couche de niobate de lithium sur substrat silicium, qui présente un coût et/ou une compatibilité optimisée vis-à-vis des procédés existants.

Un autre objectif de la présente invention est de proposer un dispositif, typiquement à onde acoustique de surface, bénéficiant d'une telle couche de niobate de lithium.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de formation d'une couche dite couche LN/LT, à base d'un matériau du type ABO3, O étant l'oxygène, A étant au moins un premier élément chimique pris parmi le sodium (Na), le potassium (K), le baryum (Ba), le lithium (Li), le plomb (Pb), et B étant au moins un deuxième élément chimique pris parmi le zirconium (Zr), le titane (Ti), le niobium (Nb), le tantale (Ta), le procédé comprenant les étapes suivantes :
- Fournir un substrat à base de silicium, de préférence cristallin, de préférence orienté selon (111),
- Former sur le substrat une couche de nucléation,
- Former par épitaxie la couche LN/LT sur la couche de nucléation.

Avantageusement, la couche de nucléation est choisie en un matériau réfractaire à base de nitrure.

Dans le cadre du développement de la présente invention, un cahier des charges pour la couche de nucléation a été établi. La couche de nucléation doit de préférence présenter les propriétés suivantes :
- Avoir une structure cristalline et/ou un paramètre de maille compatible avec un substrat à base de silicium. Cela permet par exemple d'épitaxier la couche de nucléation sur le substrat.
- Avoir une structure cristalline et/ou un paramètre de maille proche ou compatible avec le niobate de lithium ou le tantalate de lithium. Cela permet d'épitaxier la couche LN/LT sur la couche de nucléation.
- Avoir un coefficient de dilatation thermique proche du niobate de lithium ou du tantalate de lithium. Cela permet de limiter l'apparition de fissures due aux variations de températures lors de la formation de la couche LN/LT.
- Pouvoir bloquer la diffusion des atomes de Li dans le Si. Cela permet d'éviter une perte de stœchiométrie de la couche LN/LT.
- Confiner une onde acoustique, notamment en vue de garantir de hautes performances pour des dispositifs électro-acoustiques.

Un préjugé technique de l'état de la technique est qu'une telle couche de nucléation doit nécessairement être à base d'oxyde afin d'éviter une perte de stœchiométrie de la couche LN/LT due à une diffusion de l'oxygène depuis la couche LN/LT vers la couche de nucléation.

Au contraire, pour répondre à ce cahier des charges, la couche de nucléation est choisie selon la présente invention en un matériau réfractaire à base de nitrure. Cette couche de nucléation en un matériau réfractaire à base de nitrure est dénommée dans la suite couche de nucléation à base de nitrure réfractaire, par souci de concision. Dans le cadre du développement de la présente invention, il a en effet été observé qu'une telle couche de nucléation à base de nitrure réfractaire permet, de manière parfaitement inattendue, l'épitaxie de la couche LN/LT dans de bonnes conditions. De façon surprenante, il a été également observé qu'une telle couche de nucléation permet de bloquer à la fois la diffusion d'oxygène et la diffusion du lithium vers le substrat à base de silicium. Il en résulte que la couche LN/LT épitaxiée sur une telle couche de nucléation conserve la stœchiométrie requise.

Par ailleurs, les différentes structures cristallines et les paramètres de maille des nitrures réfractaires, typiquement les nitrures III-N, sont parfaitement compatibles avec celles et ceux des matériaux LN/LT et du silicium. Une telle couche de nucléation peut donc avantageusement être épitaxiée sur un substrat à base de silicium, puis permettre l'épitaxie de la couche LN/LT.

La présente invention propose ainsi une solution permettant de synthétiser une couche mince LN/LT directement sur un substrat à base de silicium - c'est-à-dire sans étape de report - par l'intermédiaire de la couche de nucléation à base de nitrure réfractaire. Grâce à la couche de nucléation à base de nitrure réfractaire, cette couche LN/LT est stœchiométrique et de haute qualité cristalline. La couche de nucléation à base de nitrure réfractaire permet en outre un bon confinement de l'onde acoustique dans la couche LN/LT.

La couche de nucléation à base de nitrure réfractaire permet ainsi d'épitaxier une couche mince LN/LT présentant les propriétés requises pour une application de type filtre SAW haute fréquence.

Selon un autre aspect de l'invention, on prévoit un dispositif à onde acoustique de surface (SAW) comprenant, en empilement selon une direction z verticale :
- un substrat à base de silicium, de préférence cristallin,
- une couche de nucléation sur ledit substrat,
- une couche LN/LT sur la couche de nucléation, ladite couche LN/LT étant à base d'un matériau du type ABO3, O étant l'oxygène, A étant au moins un premier élément chimique pris parmi le sodium (Na), le potassium (K), le baryum (Ba), le lithium (Li), le plomb (Pb), et B étant au moins un deuxième élément chimique pris parmi le zirconium (Zr), le titane (Ti), le niobium (Nb), le tantale (Ta), et
- une électrode disposée sur la couche LN/LT.

Avantageusement, la couche de nucléation du dispositif SAW est à base d'un nitrure réfractaire. Les avantages mentionnés ci-dessus s'appliquent *mutatis mutandis.* Un tel dispositif est en outre directement intégrable en technologie silicium. Il peut être facilement co-intégré avec d'autres dispositifs microélectroniques ou optoélectroniques ou encore avec des microsystèmes (opto-) électromécaniques (MEMS ou MOEMS, acronymes respectifs de « Microelectromechanical systems » et « Microoptoelectromechanical systems »).

La couche LN/LT est à base du matériau ABO3, de préférence à base de LiNbO3 ou de LiTaO3, ou d'un mélange Li(Nb,Ta)O3, ou encore à base de (K,Na)NbO3.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1A illustre en coupe transverse un dispositif selon un mode de réalisation la présente invention.
La figure 1B illustre en vue de dessus le dispositif selon le mode de réalisation illustré à la figure 1A.
La figure 2 illustre en coupe transverse un dispositif selon un autre mode de réalisation la présente invention.
La figure 3 illustre un spectre de diffraction des rayons X obtenu à partir d'une couche LN/LT épitaxiée sur une couche de nucléation à base d'AIN selon un mode de réalisation la présente invention.
La figure 4 illustre une analyse de type « rocking curve » obtenue à partir d'une couche LN/LT épitaxiée sur une couche de nucléation à base d'AIN selon un mode de réalisation la présente invention.
La figure 5 illustre une analyse de type « phi scan » obtenue à partir d'une couche LN/LT épitaxiée sur une couche de nucléation à base d'AIN sur un substrat silicium selon un mode de réalisation la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le matériau réfractaire à base de nitrure de la couche de nucléation est choisi de façon à présenter ou à former :
- Une résistance à l'oxydation,
- Une barrière à la diffusion du lithium.

Cela permet d'éviter une diffusion de l'oxygène et du lithium depuis la couche LN/LT vers la couche de nucléation. La stœchiométrie de la couche LN/LT est ainsi préservée.

Selon un exemple, le matériau réfractaire à base de nitrure de la couche de nucléation est choisi de façon à présenter une dureté ou une rigidité mécanique suffisamment élevée pour permettre de confiner une onde acoustique dans la couche LN/LT. Par exemple, le module d'Young de ce matériau est supérieur à 300 GPa. Sa dureté ou résistance peut être supérieure à 9000 MPa.

Selon un exemple, le matériau réfractaire à base de nitrure de la couche de nucléation est choisi de façon à présenter une structure cristallographique compatible avec le substrat et la couche LN/LT, telle qu'une structure hexagonale. Cela permet de limiter l'apparition de défauts structuraux lors de la formation de la couche LN/LT par épitaxie. Selon un exemple, le désaccord de paramètre de maille entre le matériau réfractaire à base de nitrure et le matériau LN/LT est inférieur à 2%. Ce désaccord de paramètre de maille peut être pris au niveau d'un sous-réseau de la cellule normale du matériau LN/LT. Par exemple, dans le cas du matériau LN/LT LiNbO3, le paramètre de maille de la cellule normale est de 5,148 Å. Dans le plan (0001), il est cependant possible de déterminer un sous-réseau hexagonal ou minicellule de 3.056 Å de paramètre de maille. Selon un exemple, si le matériau réfractaire à base de nitrure est du nitrure d'aluminium AIN qui présente un paramètre de maille de 3,112 Å, le désaccord de paramètre de maille entre la minicellule LiNbO3 et I'AIN est de l'ordre de 1,8%. L'épitaxie de LiNbO3 peut ainsi se faire sur I'AIN, de façon surprenante. Pour aligner les réseaux hexagonaux d'AIN et de la minicellule LiNbO3, une désorientation (ou « twist ») de l'ordre de 30° entre les réseaux de LiNbO3 et d'AIN apparaît typiquement, dans le plan (0001).

Selon un exemple, le matériau de type ABO3 de la couche LN/LT est choisi parmi : le niobate de lithium (LiNbO3), le tantalate de lithium (LiTaO3), ou un alliage Li(Nb,Ta)O3.

Selon un exemple alternatif, le matériau de type ABO3 de la couche LN/LT est choisi parmi : BaTiO3, Pb(Zr,Ti)O3, (K,Na)NbO3.

Selon un exemple, la formation de la couche de nucléation est configurée de sorte que ladite couche de nucléation présente une épaisseur e2 inférieure ou égale à 200 nm, de préférence inférieure ou égale à 50 nm. Cela permet de limiter l'apparition de défauts structuraux lors de la formation de la couche de nucléation par épitaxie.

Selon un exemple, la formation de la couche LN/LT est configurée de sorte que ladite couche LN/LT présente, après épitaxie, une épaisseur e3 comprise entre 50 nm et 500 nm, par exemple de l'ordre de 200 nm. Une telle épaisseur e3 correspond à une couche mince de LN/LT. Une telle épaisseur e3 ne peut pas être obtenue en pratique par report et amincissement d'une couche issue d'un substrat donneur distinct du substrat receveur.

Selon un exemple, le matériau réfractaire à base de nitrure est pris parmi les nitrures réfractaires III-N à base d'un élément du groupe III, tels que le nitrure de bore BN, le nitrure d'aluminium AIN, le nitrure de gallium GaN, le nitrure d'indium InN, et leurs alliages, par exemple AIGaN, ou les nitrures réfractaires de transition à base d'un métal de transition, tels que le nitrure de titane TiN, le nitrure de tantale TaN, le nitrure de Niobium NbN, le nitrure de zirconium ZrN, le nitrure d'hafnium HfN, le nitrure de vanadium VN.

Selon un exemple, le matériau réfractaire à base de nitrure est un nitrure réfractaire III-N pris parmi le nitrure de gallium GaN, le nitrure d'aluminium AIN, le nitrure de bore BN, ou un alliage de nitrure III-N, par exemple un alliage d'AIGaN.

Selon un exemple, le matériau réfractaire à base de nitrure de la couche de nucléation est choisi parmi un nitrure réfractaire de transition tel que du nitrure de titane TiN, du nitrure de tantale TaN, du nitrure de Niobium NbN, du nitrure de zirconium ZrN, du nitrure d'hafnium HfN, du nitrure de vanadium VN.

Selon un exemple, la formation de la couche de nucléation et la formation de la couche LN/LT sont effectuées par ablation laser pulsée successivement au sein d'un même réacteur sans remise à l'air entre lesdites formations. Cela permet d'éviter une étape de nettoyage de surface intermédiaire, de réduire la durée totale du procédé et de limiter les coûts. Cela permet également d'obtenir une faible rugosité en surface de la couche LN/LT.

Selon un exemple, le procédé comprend en outre une formation d'une électrode supérieure sur la couche LN/LT. Cela permet notamment de réaliser des dispositifs électro-acoustiques de type SAW.

Selon un exemple, le procédé comprend en outre une formation d'une couche de compensation de température, par exemple à base de SiO2, sur l'électrode supérieure et la couche LN/LT. Cela permet de diminuer la variation de fréquence de résonnance du dispositif électro-acoustique, typiquement un résonateur ou filtre SAW, sous l'effet de la température.

Selon un exemple, la couche LN/LT est directement au contact de la couche de nucléation. En particulier, il n'y a pas de couche d'oxyde intercalaire entre la couche de nucléation et la couche LN/LT.

Selon un exemple, le matériau réfractaire à base de nitrure de la couche de nucléation est un nitrure réfractaire III-N tel que du nitrure d'aluminium AIN, du nitrure de gallium GaN, du nitrure de bore BN, ou un alliage de nitrure III-N, par exemple un alliage d'AIGaN.

Selon un exemple, le matériau réfractaire à base de nitrure de la couche de nucléation est un nitrure réfractaire de transition tel que du nitrure de titane TiN, du nitrure de tantale TaN, du nitrure de Niobium NbN, du nitrure de zirconium ZrN, du nitrure d'hafnium HfN, du nitrure de vanadium VN.

Selon un exemple, la couche LN/LT présente une épaisseur e3 comprise entre 50 nm et 500 nm, par exemple de l'ordre de 100 nm ou 200 nm, de sorte que le dispositif forme un résonateur à couche mince piézoélectrique.

Selon un exemple, le dispositif comprend en outre, sur l'électrode supérieure et la couche LN/LT, une couche de compensation de température, par exemple à base de SiO2. Cela permet de diminuer la variation de fréquence de résonnance du dispositif sous l'effet de la température.

Selon un exemple, le substrat à base de silicium est formé d'un matériau pris parmi : le silicium, le SiC, le SiGe.

Selon un exemple, le substrat à base de silicium est monocristallin.

Selon un exemple alternatif, le substrat à base de silicium est polycristallin.

Selon un exemple, le substrat à base de silicium est orienté selon (111).

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques d'un aspect de l'invention, par exemple le dispositif ou le procédé, peuvent être adaptées *mutatis mutandis* à l'autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, un substrat à base de silicium s'entend par exemple d'un substrat Si, Si dopé, SiC, SiGe. Une couche à base d'AIN s'entend par exemple d'une couche AIN, AIN dopée, ou des alliages d'AIN, par exemple AIGaN.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé » se réfèrent à des positions prises selon la direction z.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans le cadre de la présente invention, un nitrure III-N est un nitrure d'élément appartenant de préférence à la colonne IIIa du tableau périodique (trois électrons de valence). Cette colonne IIIa regroupe les éléments terreux tels que le bore, l'aluminium, le gallium, l'indium. Les nitrures III-N considérés dans la présente invention sont notamment le nitrure de bore BN, le nitrure d'aluminium AIN, le nitrure de gallium GaN, le nitrure d'indium InN, et leurs alliages, par exemple et de façon non limitative AIGaN, GalnN.

Dans le cadre de la présente invention, un nitrure réfractaire de transition est un nitrure d'un métal de transition ou élément de transition (élément dont les atomes ont une sous-couche électronique d incomplète, ou qui peuvent former des cations dont la sous-couche électronique d est incomplète). Ces éléments sont regroupés au sein du bloc d du tableau périodique des éléments. Ce sont notamment les éléments Ti, Ta, Nb, Zr, Hf, V. Les nitrures réfractaires de transition considérés dans la présente invention sont notamment le nitrure de titane TiN, le nitrure de tantale TaN, le nitrure de Niobium NbN, le nitrure de zirconium ZrN, le nitrure d'hafnium HfN, le nitrure de vanadium VN.

Dans les exemples décrits ci-dessous, la couche LN/LT illustrée est à base de niobate de lithium LiNbO3. Une couche de tantalate de lithium LiTaO3 ou une couche d'un alliage Li(Ta,Nb)O3 peut être substituée à cette couche de niobate de lithium LiNbO3 dans le cadre de cette invention. Ainsi, toutes les caractéristiques et tous les effets techniques mentionnés à propos du LiNbO3 sont parfaitement applicables et combinables à une couche de LiTaO3 ou de Li(Ta,Nb)O3. D'autres matériaux ABO3 peuvent être substitués à LiNbO3, en particulier : BaTiO3, Pb(Zr,Ti)O3, (K,Na)NbO3.

Des analyses en diffraction des rayons X, par exemple en configuration 2θ, ou en rotation selon ϕ et/ou Ω (phi-scan et omega-scan), peuvent être effectuées de manière à déterminer la qualité cristalline des couches LN/LT et des couches de nucléation, et leur relation d'épitaxie.

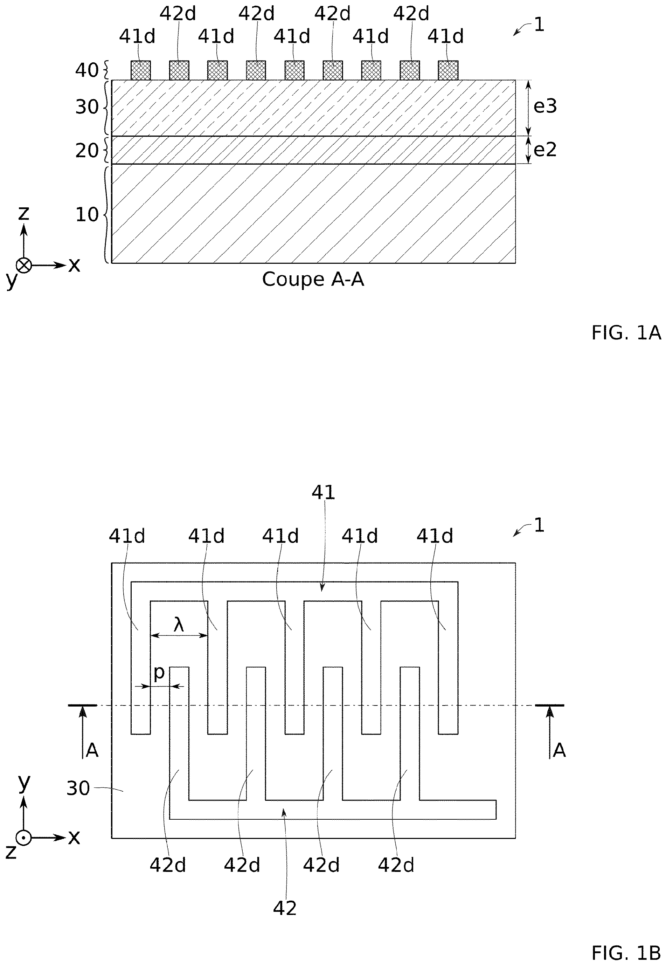

Les figures 1A et 1B illustrent un premier mode de réalisation selon l'invention. La figure 1A illustre en coupe transverse un dispositif 1 de type filtre SAW. Ce dispositif 1 comprend typiquement un substrat 10 à base de silicium sur lequel est formée une couche de nucléation 20 à base de nitrure d'aluminium AIN. Une couche 30 de niobate de lithium LiNbO3 est directement au contact de la couche de nucléation 20. Une couche d'électrode 40, comprenant des doigts d'électrode 41d, 42d, surmonte la couche 30 LN/LT.

L'utilisation d'une couche de nucléation 20 à base de nitrure réfractaire, notamment en AIN, permet avantageusement de réaliser une hétéro-épitaxie de LiNbO3 sur substrat 10 silicium. Cette solution permet de réaliser des dispositifs 1, typiquement des résonateurs, de haute performance. L'épitaxie permet notamment d'obtenir une couche de LiNbO3 stœchiométrique, orientée préférentiellement et de haute qualité cristalline. L'épaisseur de cette couche de LiNbO3 obtenue par épitaxie est en outre parfaitement contrôlée. La couche de LiNbO3 peut être formée directement sur des substrats 10 de différentes tailles, sans étape de report intermédiaire. Cela permet avantageusement de diminuer les coûts de fabrication d'un tel empilement de couches 10, 20, 30. Un tel procédé peut en outre être directement intégré dans une usine de production au standard de la technologie CMOS (transistors MOS - Métal/Oxyde/Semiconducteur - complémentaires de type N et P).

Le substrat 10 peut être un substrat massif de silicium, dit bulk. Alternativement ce substrat 10 peut être un substrat de type SOI (acronyme de « Silicon On Insulator » signifiant silicium sur isolant). D'autres substrats 10 peuvent être envisagés, par exemple des substrats à base de SiC, des substrats à base de SiGe, des substrats GeOI (acronyme de « Germanium On Insulator » signifiant germanium sur isolant). De tels substrats présentent une compatibilité totale avec les technologies silicium pour la micro-électronique. Le silicium est en outre un matériau rigide permettant de confiner une onde acoustique dans une couche supérieure de type LN/LT. Il est également conducteur thermique. Cela permet par exemple d'évacuer la chaleur générée dans un filtre SAW en fonctionnement.

La couche de nucléation 20 peut être à base de matériau III-N. Elle présente de préférence une structure cristallographique hexagonale. Une telle structure de matériau III-N permet notamment une épitaxie de la couche de nucléation sur du silicium orienté selon (001) et (111). Cela permet également d'épitaxier un matériau LN/LT selon différentes orientations cristallines. De façon préférée, le silicium est orienté selon (111). La couche de nucléation 20 est par exemple à base de nitrure d'aluminium AIN. L'AIN peut être déposé sur silicium et son procédé de dépôt est avantageusement connu et maitrisé. Le nitrure d'aluminium possède un paramètre de maille proche du niobate de lithium. Cela facilite la croissance épitaxiale du niobate de lithium. Le coefficient de dilatation thermique de I'AIN est en outre situé entre celui du LiNbO3 et celui du Si. Cela permet de limiter l'apparition de défauts structuraux dans la couche LN/LT lors des variations de température liées aux différentes étapes de dépôt. La température de fusion de I'AIN est supérieure à 2000°C, bien au-dessus de la température de dépôt du LN/LT, qui est de l'ordre de 700°C. L'AIN présente également une bonne résistance à l'oxydation, et une bonne résistance aux méthodes de dépôt de LN/LT (résistance aux plasmas d'espèces ionisées et aux précurseurs chimiques permettant de synthétiser le matériau LN/LT). L'AIN est également suffisamment rigide pour permettre un bon confinement d'une onde acoustique. Des hautes performances acoustiques peuvent ainsi être obtenues pour le dispositif 1. L'AIN peut également avantageusement servir de couche d'arrêt à la gravure de LN/LT. Cela facilite la réalisation de dispositifs électroacoustiques à couche mince de LN/LT. Cela permet également un bon contrôle dimensionnel des dispositifs. Leurs performances acoustiques sont ainsi améliorées. Le nitrure de bore et le nitrure de gallium présentent des propriétés similaires à celles mentionnées ci-dessus pour le nitrure d'aluminium. Ils peuvent également être avantageusement choisis pour la couche de nucléation 20.

La couche de nucléation 20 peut être formée par une technique de dépôt physique ou chimique, par exemple et de façon préférée par ablation laser pulsé PLD (acronyme de « Pulsed Laser Déposition »). Elle peut être alternativement formée par l'une des techniques suivantes : dépôt chimique en phase vapeur (CVD, acronyme de chemical vapor déposition), préférentiellement dépôt chimique en phase vapeur à précurseurs métal-organiques (MOCVD, acronyme de metal organic chemical vapor déposition), pulvérisation cathodique PVD (sputtering), dépôt par couche atomique assistée par plasma (PEALD, acronyme de plasma enhanced atomic layer déposition).

Elle est de préférence épitaxiée sur le substrat 10. Elle peut être monocristalline ou polycristalline avec par exemple une orientation préférentielle. Une orientation selon un plan de croissance (0001) peut être typiquement choisie pour une couche de nucléation 20 en AIN.

La couche de nucléation 20 formée sur le substrat 10 est de préférence stœchiométrique. Elle présente une épaisseur e2 comprise entre 10 et 1000 nanomètres, par exemple de l'ordre de 100 nm. L'épaisseur e2 de la couche de nucléation 20 peut être choisie en fonction de la qualité cristalline souhaitée.

La couche 30 LN/LT est de préférence à base de niobate de lithium LiNbO3 ou de tantalate de lithium LiTaO3, ou d'un alliage Li(Ta,Nb)O3. Cette couche 30 LN/LT peut être formée par une technique de dépôt physique ou chimique, par exemple et de façon préférée par ablation laser pulsé PLD. Elle peut être alternativement formée par l'une des techniques suivantes : dépôt chimique en phase vapeur (CVD, acronyme de chemical vapor déposition), préférentiellement dépôt chimique en phase vapeur à précurseurs métal-organiques (MOCVD, acronyme de metal organic chemical vapor déposition), pulvérisation cathodique PVD (sputtering), épitaxie par jet moléculaire (MBE, acronyme de Molecular Beam Epitaxy).

La couche 30 LN/LT est épitaxiée sur la couche de nucléation 20. Elle peut être monocristalline ou polycristalline, avec par exemple une orientation préférentielle. Une orientation selon un plan de croissance (0001) peut être typiquement choisie. Cela permet de maximiser la vitesse de propagation des ondes acoustiques au sein de la couche 30 LN/LT. D'autres orientations peuvent être choisies en fonction de l'application désirée.

La couche 30 LN/LT formée sur la couche de nucléation 20 est de préférence stœchiométrique, par exemple Li₁Nb₁O₃. Le pourcentage atomique de lithium est idéalement proche de 50 %. La couche 30 LN/LT présente une épaisseur e3 comprise entre 10 et 2000 nanomètres, par exemple de l'ordre de 200 nm. L'épaisseur e3 de la couche 30 LN/LT peut être choisie en fonction de l'application souhaitée.

Selon une possibilité, la couche de nucléation 20 et la couche 30 LN/LT sont toutes deux réalisées *in situ* par PLD dans un même réacteur de croissance. La croissance de la couche 30 LN/LT peut ainsi être réalisée directement après la fin de croissance de la couche de nucléation 20. Cela permet d'éviter une remise à l'air de la couche de nucléation 20 avant épitaxie de la couche 30 LN/LT. La surface de la couche de nucléation 20 reste donc propre. Cela évite une étape de nettoyage intermédiaire. La durée du procédé est ainsi diminuée. Cela permet également de limiter l'apparition de rugosité lors de la formation de la couche 30 LN/LT. L'état de surface de cette dernière est ainsi optimisé.

La couche d'électrode 40 est typiquement à base d'un matériau d'électrode électriquement conducteur. Selon une possibilité, ce matériau d'électrode peut également présenter une forte impédance acoustique. Le platine peut être choisi comme matériau d'électrode. La couche d'électrode 40 est typiquement structurée de façon à présenter des motifs d'électrode 41d, 42d. Une telle électrode 40 est typiquement formée par lithographie/gravure à partir d'une couche électriquement conductrice déposée sur la couche 30 LN/LT.

La figure 1B illustre en vue de dessus le dispositif 1. Dans cet exemple, l'électrode supérieure 40 se présente sous forme de deux peignes interdigités 41, 42. Les doigts 41d, 42d de ces peignes 41, 42 sont typiquement séparés par un pas p de l'ordre de quelques centaines de nanomètres à quelques microns. La période λ séparant deux doigts 41d, 42d consécutifs d'un même peigne 41, 42 est typiquement de l'ordre de quelques centaines de nanomètres à quelques microns. Les motifs 41, 41d, 42, 42d de l'électrode 40 peuvent présenter d'autres formes. Le design de ces motifs d'électrode 40 peut être adapté en fonction des besoins.

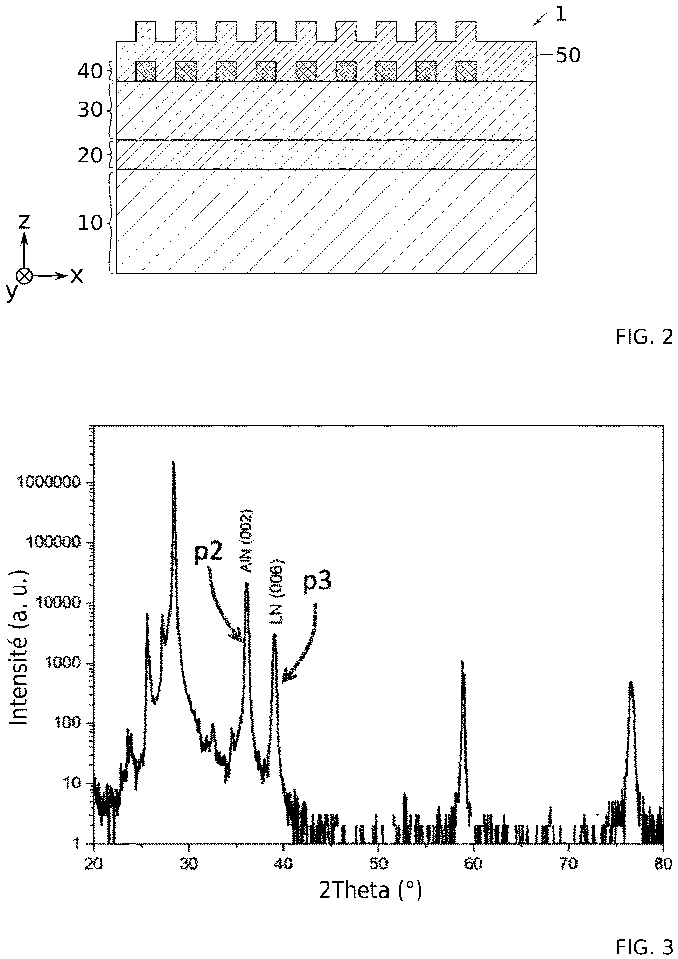

La figure 2 illustre un autre mode de réalisation du dispositif 1. Dans cet exemple, une couche 50 de compensation thermique est formée par-dessus l'électrode supérieure 40. Cette couche 50 peut être formée par dépôt conforme sur les motifs d'électrode et entre les motifs d'électrode, sur la couche 30 LN/LT, comme illustré sur la figure 2. Elle peut être typiquement déposée par CVD. La couche 50 de compensation thermique peut être par exemple à base de SiO2. Elle permet notamment de diminuer la variation de fréquence de résonance du dispositif 1 sous l'effet de la température. La fréquence de résonance et la bande passante du dispositif 1 sont ainsi avantageusement stabilisées au cours de l'utilisation du dispositif 1.

La figure 3 illustre une analyse symétrique en diffraction des rayons X ou XRD (acronyme de X-Ray Diffraction) effectuée sur un empilement de couches 10, 20, 30 comprenant une couche de nucléation en AIN et une couche LN/LT en niobate de lithium LiNbO3.

Le pic p2 correspond à I'AIN stœchiométrique et orienté selon le plan (002). Le pic p3 correspond au LiNbO3 stœchiométrique et orienté selon le plan (006). Cette analyse XRD symétrique montre que les couches d'AIN et de LiNbO3 obtenus par le procédé selon l'invention sont stœchiométriques et orientées.

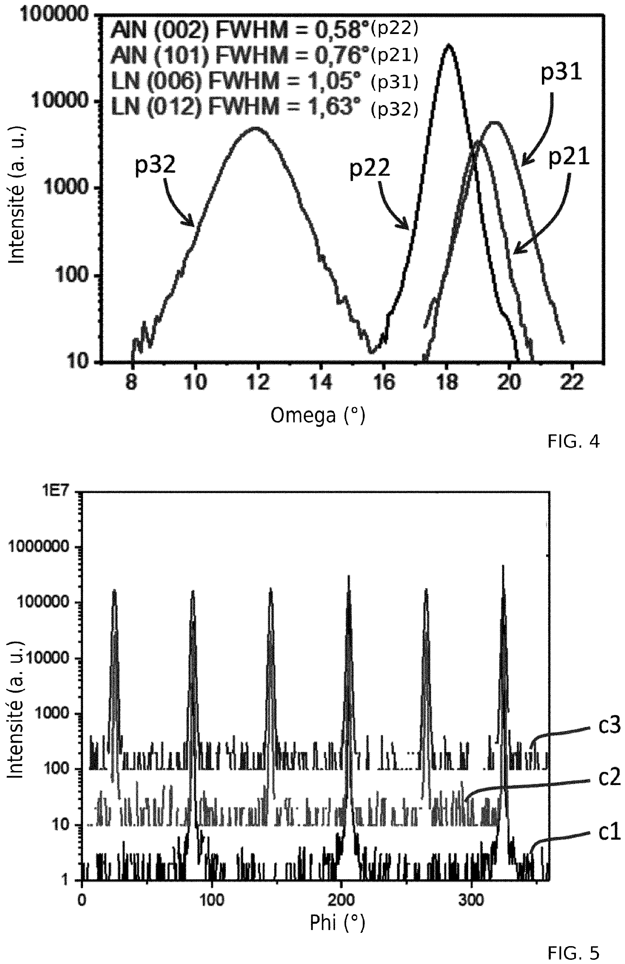

La figure 4 illustre une analyse dite « Rocking Curve » (ou courbe d'oscillation en français) effectuée sur l'empilement de couches 10, 20, 30. Le pic p21 correspond à un scan oméga réalisé autour du plan (101) de l'AIN. La largeur à mi-hauteur FWHM (acronyme de « full width at half maximum ») de ce pic p21 est faible, ici de l'ordre de 0,58°. Cela indique que la désorientation des cristallites d'AIN orientées selon (101) est faible. Le pic p22 correspond à un scan oméga réalisé autour du plan (002) de l'AIN. La largeur à mi-hauteur FWHM de ce pic p22 est faible, ici de l'ordre de 0,76°. Cela indique que la désorientation des cristallites d'AIN orientées selon (002) est faible. Le pic p31 correspond à un scan oméga réalisé autour du plan (006) du LiNbO3. La largeur à mi-hauteur FWHM de ce pic p31 est faible, ici de l'ordre de 1,05°. Cela indique que la désorientation des cristallites de LiNbO3 orientées selon (006) est faible. Le pic p32 correspond à un scan oméga réalisé autour du plan (012) du LiNbO3. La largeur à mi-hauteur FWHM de ce pic p32 est faible, ici de l'ordre de 1,63°. Cela indique que la désorientation des cristallites de LiNbO3 orientées selon (012) est faible.

La couche 20 d'AIN et la couche 30 de LiNbO3 obtenues par le procédé selon l'invention sont donc bien texturées.

La figure 5 illustre une analyse dite « phi-scan » effectuée sur l'empilement de couches 10, 20, 30. La courbe c1 correspond à un scan phi réalisé pour le plan (220) du Si. La courbe c2 correspond à un scan phi réalisé pour le plan (101) de l'AIN. La courbe c3 correspond à un scan phi réalisé pour le plan (116) du LiNbO3. Une relation d'épitaxie entre AIN et Si d'une part, et entre AIN et LiNbO3 d'autre part, est mise en évidence par la périodicité des pics de diffraction. Les couches 20 d'AIN et 30 de LiNbO3 obtenues par le procédé selon l'invention sont donc bien épitaxiées.

La présente invention permet avantageusement de former des couches minces LN/LT de bonne qualité cristalline sur des substrats à base de silicium comprenant une couche de nucléation en un matériau réfractaire à base de nitrure, typiquement à base de matériaux III-N. Ces couches minces LN/LT sont avantageusement directement intégrables dans des dispositifs électro-acoustiques de type résonateurs SAW ou filtres RF. D'autres applications peuvent être envisagées. L'invention n'est pas limitée aux modes de réalisation précédemment décrits.

## Revendications

1. Procédé de formation d'une couche (30) dite couche LN/LT, à base d'un matériau ABO3, O étant l'oxygène, A étant au moins un premier élément chimique pris parmi le sodium (Na), le potassium (K), le baryum (Ba), le lithium (Li), le plomb (Pb), et B étant au moins un deuxième élément chimique pris parmi le zirconium (Zr), le titane (Ti), le niobium (Nb), le tantale (Ta), ledit procédé comprenant les étapes suivantes :
• Fournir un substrat (10) à base de silicium,
• Former sur le substrat (10) une couche de nucléation (20),
• Former par épitaxie la couche LN/LT (30) sur la couche de nucléation (20),
Le procédé étant **caractérisé en ce que** la couche de nucléation (20) est choisie en un matériau réfractaire à base de nitrure et **en ce que** le substrat (10) est à base de silicium orienté selon (111), la couche de nucléation (20) est à base de nitrure d'aluminium AIN orienté selon (0001), et la couche LN/LT (30) est orientée selon (0001).

2. Procédé selon la revendication précédente dans lequel le matériau réfractaire à base de nitrure est pris parmi les nitrures réfractaires III-N à base d'un élément du groupe III, tels que le nitrure de bore BN, le nitrure d'aluminium AIN, le nitrure de gallium GaN, le nitrure d'indium InN, et leurs alliages, par exemple AIGaN, ou les nitrures réfractaires de transition à base d'un métal de transition, tels que le nitrure de titane TiN, le nitrure de tantale TaN, le nitrure de Niobium NbN, le nitrure de zirconium ZrN, le nitrure d'hafnium HfN, le nitrure de vanadium VN.

3. Procédé selon la revendication précédente dans lequel le matériau réfractaire à base de nitrure est un nitrure réfractaire III-N pris parmi le nitrure de gallium GaN, le nitrure d'aluminium AIN, et l'alliage AIGaN.

4. Procédé selon l'une quelconque des revendications précédentes dans lequel le matériau de type ABO3 de la couche LN/LT (30) est choisi parmi : le niobate de lithium (LiNbO3), le tantalate de lithium (LiTaO3), ou un alliage Li(Nb,Ta)O3.

5. Procédé selon l'une quelconque des revendications précédentes dans lequel la formation de la couche de nucléation (20) est configurée de sorte que ladite couche de nucléation (20) présente une épaisseur e2 inférieure ou égale à 200 nm, de préférence inférieure ou égale à 50 nm.

6. Procédé selon l'une quelconque des revendications précédentes dans lequel la formation de la couche LN/LT (30), est configurée de sorte que ladite couche LN/LT (30) présente, après épitaxie, une épaisseur e3 comprise entre 50 nm et 500 nm, par exemple de l'ordre de 200 nm.

7. Procédé selon l'une quelconque des revendications précédentes dans lequel la formation de la couche de nucléation (20) et la formation de la couche LN/LT (30) sont effectuées par ablation laser pulsée successivement au sein d'un même réacteur sans remise à l'air entre lesdites formations.

8. Procédé selon l'une quelconque des revendications précédentes dans lequel le substrat (10) à base de silicium est formé d'un matériau pris parmi : le silicium, le SiC, le SiGe.

9. Dispositif (1) comprenant, en empilement selon une direction dite verticale (z), un substrat (10) à base de silicium, une couche de nucléation (20) sur ledit substrat (10), une couche (30) dite couche LN/LT sur ladite couche de nucléation (20), la couche LN/LT étant à base d'un matériau du type ABO3, O étant l'oxygène, A étant au moins un premier élément chimique pris parmi le sodium (Na), le potassium (K), le baryum (Ba), le lithium (Li), le plomb (Pb), et B étant au moins un deuxième élément chimique pris parmi le zirconium (Zr), le titane (Ti), le niobium (Nb), le tantale (Ta), ledit dispositif (1) comprenant en outre au moins une électrode (40, 41, 42) supérieure disposée sur la couche LN/LT (30), le dispositif (1) étant **caractérisé en ce que** la couche de nucléation (20) est en un matériau réfractaire à base de nitrure.

10. Dispositif (1) selon la revendication précédente dans lequel la couche LN/LT (30) est directement au contact de la couche de nucléation (20).

11. Dispositif (1) selon l'une quelconque des revendications 9 à 10, dans lequel le matériau réfractaire à base de nitrure est pris parmi les nitrures réfractaires III-N à base d'un élément du groupe III, ou les nitrures réfractaires de transition à base d'un métal de transition.

12. Dispositif (1) selon l'une quelconque des revendications 9 à 11, dans lequel la couche LN/LT (30) présente une épaisseur e3 comprise entre 50 nm et 500 nm, de sorte que le dispositif (1) forme un résonateur à couche mince piézoélectrique, par exemple du type filtre à onde acoustique de surface.

13. Dispositif (1) selon l'une quelconque des revendications 9 à 12, comprenant en outre, sur l'électrode (40, 41, 42) supérieure et la couche LN/LT (30), une couche (50) de compensation de température, par exemple à base de SiO2.

14. Dispositif (1) selon l'une quelconque des revendications 9 à 13, dans lequel le substrat (10) à base de silicium est monocristallin.
